(19) Europäisches Patentamt / European Patent Office / Office européen des brevets

(11) **EP 1 248 282 B1**

(12) **EUROPÄISCHE PATENTSCHRIFT**

(45) Veröffentlichungstag und Bekanntmachung des Hinweises auf die Patenterteilung:
**28.11.2007 Patentblatt 2007/48**

(51) Int Cl.:
***H01J 37/317*** *(2006.01)*    ***H01J 37/30*** *(2006.01)*
***G03F 7/20*** *(2006.01)*

(21) Anmeldenummer: **02007523.0**

(22) Anmeldetag: **02.04.2002**

(54) **Teilchenoptische Vorrichtung, Beleuchtungsvorrichtung und Projektionssystem sowie Verfahren unter Verwendung derselben**

Particle-optical device, illumination device and projection system, and method using them

Illumination system for charged-particle lithography apparatus ¬2001/49 Dispositif d'optique corpusculaire, dispositif d'illumination et système de projection ainsi que méthode utilisant ceux-ci

(84) Benannte Vertragsstaaten:
**DE FR GB IT NL**

(30) Priorität: **05.04.2001 DE 10117025**

(43) Veröffentlichungstag der Anmeldung:
**09.10.2002 Patentblatt 2002/41**

(73) Patentinhaber: **Carl Zeiss SMT AG**
**73447 Oberkochen (DE)**

(72) Erfinder: **Kienzle, Oliver, Dr.**
**73430 Aalen (DE)**

(74) Vertreter: **Schorr, Frank Jürgen et al**
**Diehl & Partner,**
**Augustenstrasse 46**
**80333 München (DE)**

(56) Entgegenhaltungen:
**US-A- 3 735 128        US-A- 5 633 507**
**US-A- 6 069 684**

• **D.MOONEN ET AL: "Grid lens approach for high effective emittance in SCALPEL" J.VAC. SCI. TECHNOL. B, Bd. 18, Nr. 6, - 2000 Seiten 3111-3114, XP002203648**

**Beschreibung**

Die Erfindung betrifft eine teilchenoptische Vorrichtung zum Ändern von Trajektorien geladener Teilchen eines Teilchenstrahls. Die Erfindung betrifft ferner eine Beleuchtungsvorrichtung und ein Projektionssystem, welche eine solche teilchenoptische Vorrichtung umfassen, sowie ein Verfahren zur Herstellung eines Bauelements, wobei das Verfahren einen photolithographischen Schritt umfaßt, bei dem die teilchenoptische Vorrichtung zum Einsatz kommt. Insbesondere ist die teilchenoptische Vorrichtung zum Einsatz in einem Elektronenstrahl-Projektionslithographiesystem sowie zum Einsatz in einem Verfahren zur Herstellung eines Bauelements mittels Elektronenstrahl-Projektionslithographie vorgesehen.

Als ein Verfahren, das mit einem Elektronenstrahl zur Abbildung und Belichtung der strahlungsempfindlichen Schicht arbeitet, ist das sogenannte SCALPEL-Verfahren (Scattering with Angular Limitation in "Projection Electron-beam Lithography") bekannt. Dieses Verfahren ist beschrieben in dem Weisbuch "SCALPEL: A Projection Electron-Beam Approach to Sub-Optical Lithography", Technology Review, Dezember 1999, von J. A. Liddle, Lloyd R. Harriott, A.E. Novembre und W. K. Waskiewicz, Bell Laboratories, Lucent Technologies, 600 Mountain Avenue, Murray Hill, New Jersey 07974, USA. Weiterhin betreffen die Patentdokumente US 5 079 112, US 5 130 213, US 5 260 151, US 5 376 505, US 5 258 246, US 5 316 879 sowie EP 0 953 876 A2 und EP 0 969 326 A2 das SCALPEL-Verfahren.

In dem Dokument "Grid lens approach for high effective emittance in SCALPEL" von D. Moonen, veröffentlicht in dem "Journal for Vacuum Sience Technology", Nov/Dec 2000, wird vorgeschlagen, in einem Strahlengang eines SCALPEL-Systems eine Vielzahl von Linsen anzuordnen. Dabei sind diese Linsen nebeneinander in einer von dem Strahlengang senkrecht durchdrungenen Ebene angeordnet. Im Falle der Verwendung eines Elektronenstrahls können die Linsen durch drei benachbart angeordnete Gitter, die auf unterschiedlichen Potentialen liegen, gebildet sein. Dabei werden die Gitter durch sich geradlinig in zueinander parallelen Ebenen erstreckende Drähte gebildet, wobei die zueinander parallelen Ebenen von dem Strahlengang senkrecht durchdrungen werden.

Aus dem britischen Patent GB 1 469 415 ist ein elektrostatischer Teilchenanalysator bekannt. Der Analysator weist eine zylindrische äußere Elektrode und eine zylindrische innere Elektrode auf, wobei die Elektroden koaxial mit einer Achse des Analysators angeordnet sind. Die innere Elektrode besteht aus drei in axialer Richtung des Analysators beabstandeten Abschnitten zwischen denen ein Eingangsspalt und ein Ausgangsspalt für geladene Partikel gebildet ist. Mittels eines Elektronenstrahls werden aus einem betrachteten Objekt geladene Partikel gelöst. Nach Durchlaufen des Eingangsschlitzes gelangen die geladenen Partikel in ein zwischen den Elektroden aufgebautes Feld und werden von diesem Feld entsprechend der Spannung zwischen den Elektroden in Richtung der inneren Elektrode abgelenkt. Geladene Partikel mit einer vorgegebenen Energie, welche von dem Spannungsunterschied zwischen den beiden Elektroden abhängt, passieren den Ausgangsspalt und treffen auf einen an der zentralen Achse des Analysators angeordneten Detektor.

Ein herkömmliches Projektionslithographiesystem wird beispielsweise zur Herstellung eines Halbleiter-Bauelements eingesetzt. Hierbei sind die auf einem Halbleiter-Wafer auszubildenden Strukturen in einer Maske definiert, die Maske wird mit einem Elektronenstrahl beleuchtet, und die auf der Maske definierten Strukturen werden auf den Halbleiter-Wafer abgebildet. Der Halbleiter-Wafer ist mit einer strahlungsempfindlichen Schicht versehen, und nach der Belichtung mit dem Elektronenstrahl werden die strahlungsempfindliche Schicht sowie der Halbleiter-Wafer weiteren Schritten zur Ausbildung der Strukturen in dem Wafermaterial unterzogen.

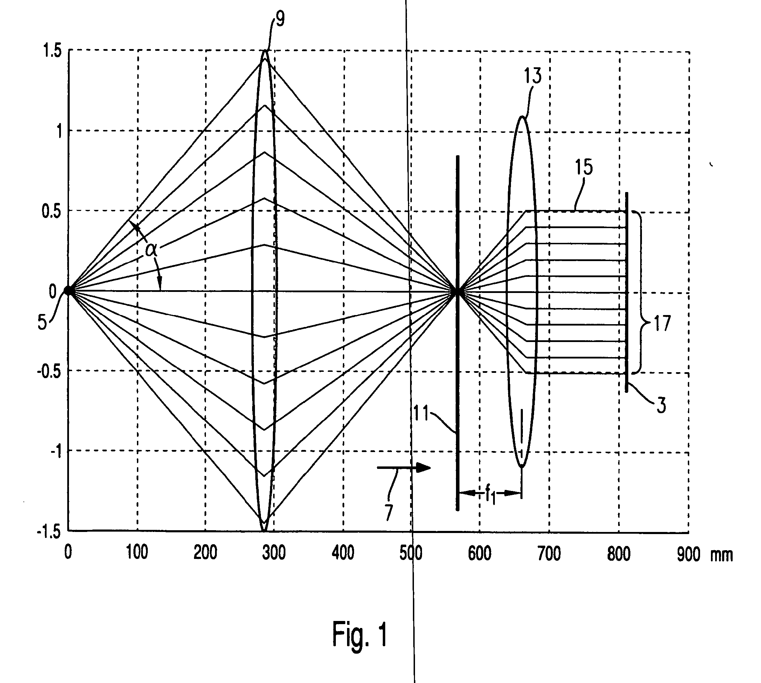

In Figur 1 ist eine Beleuchtungsvorrichtung zur Beleuchtung einer Maske 3 mit geladenen Teilchen schematisch dargestellt. Die geladenen Teilchen sind Elektronen, die von einer Elektronenquelle 5 in eine Strahlrichtung 7 emittiert werden. Der von der Quelle 5 emittierte Teilchenstrahl weist eine geringe Divergenz auf, die allerdings in der Figur 1 zur Verdeutlichung vergrößert dargestellt ist. Ein maximaler Winkel $\alpha$ der Elektronen zur Strahlrichtung 7 beträgt etwa 5mrad.

Durch eine erste elektronenoptische fokussierende Linse 9 wird die Quelle in eine vordere Brennebene 11 einer zweiten elektronenoptischen Fokussierlinse 13 abgebildet. Die Fokussierlinse 13 formt aus den die Brennebene 11 divergent durchsetzenden Elektronen einen im wesentlichen parallelen Teilchenstrahl 15 mit ausgedehntem Strahlquerschnitt, um auf der Maske 3 ein Feld 17 mit einer Ausdehnung von etwa 1mm quer zur Strahlrichtung 7 zu beleuchten.

Die maximale Beleuchtungsapertur, die bei dieser Art der Beleuchtung erreicht werden kann, ist durch die räumliche Ausdehnung h quer zur Strahlrichtung 7 der Quelle 5 sowie die Brennweite $f_1$ der Linse 13 gegeben. Der maximale Winkel $\beta$ der Teilchen bezüglich der Strahlrichtung 7 bei deren Auftreffen auf die Maske 3 ist

gegeben durch $\beta = \dfrac{h}{2 f_1}$ . Für kleine Ausdehnungen der Quelle 3 (in Figur 1 ist eine punktförmige Quelle dargestellt) ist somit die Beleuchtungsapertur gering. Allerdings ist eine hohe Beleuchtungsapertur wünschenswert, um auch kleine auf der Maske definierte Strukturen präzise auf den Wafer übertragen zu können.

Es ist denkbar, die räumliche Ausdehnung quer zur Strahlrichtung der Quelle zu erhöhen, um die Beleuchtungsapertur zu erhöhen. Bei Quellen für geladene Teilchen ist eine Erhöhung der Quellausdehnung allerdings problematisch, wenn das auf der Maske beleuchtete Feld zudem auch gleichförmig ausgeleuchtet werden soll.

Es ist eine Aufgabe der vorliegenden Erfindung, eine teilchenoptische Vorrichtung bereitzustellen, welche zur Erhöhung einer Beleuchtungsapertur in einem teilchenoptischen Beleuchtungssystem beiträgt.

Ferner ist es eine Aufgabe der vorliegenden Erfindung, eine teilchenoptische Vorrichtung zum Ändern von Trajektorien geladener Teilchen eines Teilchenstrahls vorzuschlagen. Insbesondere ist es hierbei eine Aufgabe der Erfindung, eine teilchenoptische Vorrichtung vorzuschlagen, welche die Trajektorien der geladenen Teilchen selektiv ändert, das heißt welche nur auf Trajektorien bestimmter geladener Teilchen und nicht gleichförmig auf die Trajektorien sämtlicher Teilchen eines Teilchenstrahls einwirkt.

Eine Aufgabe der vorliegenden Erfindung ist es ferner, eine Beleuchtungsvorrichtung vorzuschlagen, welche eine Beleuchtung eines zu beleuchtenden quer zur Strahlrichtung räumlich ausgedehnten Feldes mit vergleichsweise hoher Beleuchtungsapertur oder/und vergleichsweise gleichförmig zu beleuchten.

Ferner ist es eine Aufgabe, ein Projektionssystem vorzuschlagen, dessen Beleuchtungsvorrichtung die oben genannten Vorteile aufweist, und noch eine weitere Aufgabe der Erfindung ist es, ein Verfahren zur Herstellung insbesondere miniaturisierter Bauelemente vorzuschlagen, welches eine erhöhte Präzision bei der Fertigung der Bauelemente ermöglicht.

Der Erfindung liegt hierzu folgende Überlegung zugrunde:

In einem abbildenden Beleuchtungssystem, wie es beispielhaft anhand der Figur 1 vorangehend erläutert wurde, ist der Lichtleitwert bzw. die Emittanz eine Erhaltungsgröße. Diese Größe ist definiert als das Produkt aus Quadratwurzel der beleuchteten Fläche und der Beleuchtungsdivergenz (numerische Apertur). Eine Erhöhung der Beleuchtungsdivergenz ist somit ohne Verringerung der beleuchteten Fläche mit einem abbildenden Beleuchtungssystem nicht zu erreichen. Deshalb liegt der Erfindung die Idee zugrunde, eine teilchenoptische Vorrichtung zu entwickeln, welche nicht als abbildendes System arbeitet, sondern die Trajektorien der die teilchenoptische Vorrichtung durchsetzenden geladenen Teilchen auf andere Weise ändert. Hierbei soll die Änderung der Trajektorien der geladenen Teilchen für verschiedene Gruppen der Teilchen jeweils verschieden und derart sein, daß sich insgesamt eine Erhöhung des Lichtleitwerts bzw. der Emittanz des die Vorrichtung durchsetzenden Strahls ergibt.

Die vorstehende Aufgabe wird erfindungsgemäß mittels einer teilchenoptischen Belechtungsvorrichtung mit der Kombination der Merkmale des unabhängigen Anspruches 1 gelöst. Vorteilhafte Weiterbildungen finden sich in den Unteransprüchen.

Die erfindungsgemäße Belechtungsvorrichtung ist insbesondere geeignet, in einem Abbildungssystem zur Übertragung eines auf einer Maske definierten Musters mittels eines Strahls geladener Teilchen auf ein teilchenempfindliches Substrat und in einem Verfahren zur Herstellung eines Bauelements verwendet zu werden.

Die Erfindung schlägt insbesondere eine teilchenoptische Vorrichtung vor, welche zwei ineinander angeordnete zylindrische Elektrodenanordnungen aufweist, die relativ zu einem in die Vorrichtung eintretenden Teilchenstrahl derart angeordnet sind, daß die Strahlrichtung in etwa parallel zur Erstreckungsrichtung wenigstens einer der zylindrischen Elektrodenanordnungen ausgerichtet ist. Ferner weist eine innere der beiden Elektrodenanordnungen eine solche Länge bzw. einen solchen Durchmesser auf, daß Trajektorien wenigstens der Teilchen, die in die Vorrichtung unter einem Winkel zur Strahlachse eintreten, der größer ist als ein Mindestwinkel, die innere Elektrodenanordnung bezüglich der Strahlrichtung radial durchsetzen. Hierzu ist die innere Elektrodenanordnung für die geladenen Teilchen wenigstens teilweise transparent. Zwischen der inneren Elektrodenanordnung und der äußeren Elektrodenanordnung besteht eine elektrische Potentialdifferenz derart, daß eine quer zur Strahlrichtung orientierte Bewegungskomponente der die innere Elektrodenanordnung durchsetzenden Teilchen umgekehrt wird.

Die innere und die äußere Elektrodenanordnung wirken zusammen wie ein den Teilchenstrahl umschließendes zylindrisches und innen verspiegeltes Rohr, welches Teilchen, die den Zylinderinnenraum verlassen wollen, in diesen zurückreflektiert.

Auf eine Gruppe von Teilchen des Teilchenstrahls, welche mit geringer Divergenz in die Vorrichtung eintreten, ist die Vorrichtung nicht wirksam, das heißt diese Gruppe von Teilchen durchsetzt die Vorrichtung geradlinig, so daß ein an der Austrittsseite der Vorrichtung angeordneter Betrachter diese Teilchen aus der Teilchenquelle herkommend sieht.

Für eine andere Gruppe von Teilchen mit erhöhter Divergenz wirkt die Vorrichtung vorzugsweise derart, daß die Teilchen einmal von dem spiegelnden Rohr reflektiert werden. Diese Gruppe von Teilchen scheint für den Betrachter von einer räumlich verteilten Quelle herzukommen, welche neben der tatsächlichen Quelle angeordnet zu sein scheint.

Für eine noch weitere Gruppe von Teilchen mit noch höherer Divergenz wirkt die Vorrichtung derart, daß diese Teilchen zweifach oder mehrfach von dem spiegelnden Rohr reflektiert werden, so daß für den Betrachter diese Gruppen von Teilchen von weiteren räumlich verteilten Quellen herzurühren scheinen, welche mit noch größerem Abstand von der tatsächlichen Quelle angeordnet sind.

Somit wirkt die erfindungsgemäße Vorrichtung derart, daß selbst eine kleine Strahlungsquelle für einen Betrachter wie eine Strahlungsquelle mit einer wesentlich erhöhten strahlungsemittierenden Fläche erscheint.

Wird eine solche teilchenoptische Vorrichtung in einem Beleuchtungssystem eingesetzt, so trägt sie zu einer scheinbaren Erhöhung der räumlichen Ausdehnung der Strahlungsquelle quer zur Strahlrichtung bei, was zu einer Erhöhung des Lichtleitwerts bzw. der Emittanz des Beleuchtungssystems führt, weshalb die erfindungsgemäße Vorrichtung auch die Erhöhung der Beleuchtungsapertur bei einem quer zur Strahlrichtung ausgedehnten beleuchteten Feld ermöglicht.

Aufgrund der Potentialdifferenz zwischen der inneren und der äußeren Elektrodenanordnung ist zwischen diesen beiden Elektrodenanordnungen ein Raum gebildet, in dem ein elektrisches Feld herrscht, das die Umkehrung der Transversalbewegungskomponente der in diesen Raum eindringenden Teilchen ermöglicht. Da dieses Feld auf den Raum zwischen der inneren und der äußeren Elektrodenanordnung beschränkt ist, muß ein Eintritt der geladenen Teilchen in diesen Raum ermöglicht werden, weshalb die innere Elektrodenanordnung für die Teilchen wenigstens teilweise transparent ist. Vorzugsweise wird diese Eigenschaft der Teiltransparenz der inneren Elektrodenanordnung dadurch bereitgestellt, daß die innere Elektrodenanordnung in eine Mehrzahl von Teilelektroden untergliedert ist, welche mit Abstand voneinander angeordnet sind. Die einzelnen Teilelektroden liegen vorzugsweise auf einem gemeinsamen gleichen elektrischen Potential, und zwischen den Teilelektroden ist ein materialfreier Raum vorgesehen, so daß die Teilchen zwischen zwei benachbarten Teilelektroden hindurchtreten und in den das spiegelnde elektrische Feld breitstellenden Raum zwischen innerer und äußerer Elektrodenanordnung eindringen können. Allerdings ist es dabei möglich, daß Teilchen unmittelbar auf die Teilelektroden treffen und damit nicht in den Raum zwischen innerer und äußerer Elektrode eindringen können.

Um eine möglichst hohe Transparenz für die geladenen Teilchen zu erhalten, erstrecken sich die Teilelektroden vorzugsweise im wesentlichen parallel zur Längsachse der Vorrichtung oder/und im wesentlichen parallel zur Hauptrichtung des in die Vorrichtung eintretenden Teilchenstrahls.

Ist die vorangehend beschriebene teilchenoptische Vorrichtung in einer Beleuchtungsvorrichtung zum Beleuchten eines Objekts eingesetzt, so wirkt sie dort als eine Emittanzänderungsvorrichtung, welche vorzugsweise zwischen einer Teilchenquelle und der Objektebene angeordnet ist. Vorzugsweise umfaßt eine solche Beleuchtungsvorrichtung auch ein abbildendes Kondensorsystem, welches zwischen der Emittanzänderungsvorrichtung und dem Objekt angeordnet ist und die aus der Emittanzänderungsvorrichtung austretenden Teilchen auf das Objekt richtet.

Die von der Teilchenquelle emittierten Teilchen treten vorzugsweise unmittelbar in die Emittanzänderungsvorrichtung ein. Weiterhin ist es allerdings auch bevorzugt, zwischen der Teilchenquelle und der Emittanzänderungsvorrichtung ein optisches System vorzusehen, welches ein Bild der Quelle erzeugt, welches zwischen der eigentlichen Quelle und einem Eintrittsquerschnitt der Emittanzänderungsvorrichtung angeordnet ist.

Das Kondensorsystem umfaßt vorzugsweise eine Fokussierlinse, welche die Quelle selbst oder das Bild der Quelle in eine Zwischenebene abbildet, welche zwischen der Emittanzänderungsvorrichtung und der Objektebene angeordnet ist. Hierbei entstehen dann in der Zwischenebene vorzugsweise mehrere Bilder der Quelle selbst, wenn die erste Fokussierlinse die Quelle in die Zwischenbildebene abbildet, und es entstehen mehrere Bilder des Bildes der Quelle, wenn die erste Fokussierlinse ein Bild der Quelle in die Zwischenbildebene abbildet. Diese mehreren Bilder der Quelle bzw. Bilder der Quellbilder sind in der Zwischenbildebene verteilt, insbesondere einander benachbart, angeordnet.

Es ist jedoch ebenfalls bevorzugt, daß die erste Fokussierlinse in der Zwischenebene nicht ein exaktes Bild der Quelle bzw. des Quellbildes erzeugt. Wesentlich ist dann, daß die erste Fokussierlinse die Teilchen, welche die Emittanzänderungsvorrichtung durchlaufen haben, derart durch die Zwischenebene lenkt, daß sie in der Zwischenebene einen Abstand von der Längsachse der Vorrichtung bzw. der Strahlmitte haben, welcher um so größer ist, je öfter die Trajektorie eines Teilchens durch die Emittanzänderungsvorrichtung geändert wurde. In der Zwischenebene entsteht somit im Vergleich zu einer Situation, in der die Emittanzänderungsvorrichtung nicht im Strahlengang angeordnet ist, ein vergrößerter beleuchteter bzw. von Teilchen durchsetzter Bereich. Die diesen vergrößerten Bereich durchsetzenden Teilchen werden vorzugsweise mittels einer zweiten Fokussierlinse derart auf die Objektebene gelenkt, daß dort ein Feld beleuchtet wird, welches quer zur Strahlrichtung eine Ausdehnung aufweist, die geringer ist als die Ausdehnung des beleuchteten Bereichs in der Zwischenebene. Allerdings erfolgt die Beleuchtung dieses Bereichs in der Objektebene dann im Vergleich zu der Situation, bei der die Emittanzänderungsvorrichtung nicht im Strahlengang angeordnet ist, mit einer erhöhten numerischen Apertur.

Die Erfindung sieht ebenfalls ein Verfahren zur Herstellung eines Bauelements vor, wobei es sich vorzugsweise um stark miniaturisierte Bauelemente, wie etwa mikromechanische Strukturen oder integrierte Schaltungen handelt. Im Fall der integrierten Schaltung enthält eine Maske ein Schaltungsmuster, das einer einzelnen Schicht der auf einem geeigneten Substrat, beispielsweise einem Silizium-Wafer, auszubildenden Schaltung entspricht. Zur Abbildung des Musters auf einen Zielbereich (englisch "Die") des Substrats wird letzteres zunächst mit einer strahlungsempfindlichen Schicht ("resist") bedeckt. Sodann wird die strahlungsempfindliche Schicht exponiert bzw. belichtet, indem das Muster der Maske mittels geladener Teilchen, beispielsweise Elektronen oder Ionen, auf die strahlungsempfindliche Schicht abgebildet wird. Die strahlungsempfindliche Schicht wird daraufhin entwickelt, und es werden entweder die belichteten bzw. exponierten oder die unbelichteten bzw. nicht exponierten Bereiche der belichteten Schicht abgetragen. Die verbleibende Struktur der strahlungsempfindlichen Schicht dient dann als Maske in beispielsweise einem Ätzschritt, einem Ionenimplantationsschritt, einem Materialabscheidungsschritt oder ähnlichem.

Erfindungsgemäß ist hierbei vorgesehen, in einem photolithographischen Schritt des Verfahrens die Maske und die auf der Maske definierte auf das Substrat abzubildende Struktur mittels der vorangehend erläuterten Beleuchtungsvorrichtung zu beleuchten.

Im folgenden werden Ausführungsbeispiele der Erfindung anhand von Zeichnungen näher erläutert. Hierbei zeigt:

Figur 1     eine Beleuchtungsvorrichtung, in deren Strahlengang eine erfindungsgemäße teilchenoptische Vorrichtung nicht angeordnet ist,

Figur 2     eine Ausführungsform einer erfindungsgemäßen teilchenoptischen Vorrichtung in schematisch perspektivischer Darstellung,

Figur 3     die teilchenoptische Vorrichtung gemäß Figur 1 in einer Schnittdarstellung,

Figur 4     eine Darstellung zur Funktion der in den Figuren 2 und 3 gezeigten Vorrichtung,

Figur 5     eine vergrößerte Darstellung eines in Figur 4 mit V gekennzeichneten Bereichs desselben,

Figur 6     eine weitere erläuternde Darstellung zur Funktion der in den Figuren 2 und 3 gezeigten Vorrichtung,

Figur 7     eine Ausführungsform eines erfindungsgemäßen Beleuchtungssystems und

Figur 8     eine Teilansicht einer Ausführungsform eines erfindungsgemäßen Projektionssystems.

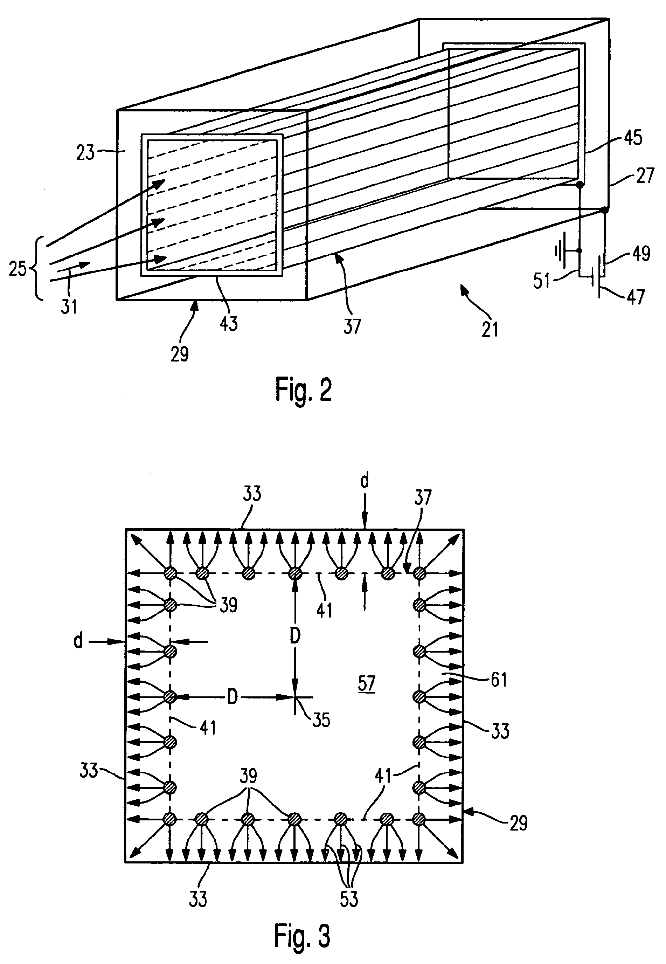

Eine in Figur 2 dargestellte Emittanzänderungsvorrichtung 21 dient dazu, einen auf einer Eintrittsseite 23 der Vorrichtung 21 eintretenden Strahl 25 geladener Teilchen derart zu ändern, daß die Emittanz des Strahls nach dessen Austritt auf einer der Eintrittsseite 23 gegenüberliegenden Austrittsseite 27 der Emittanzänderungsvorrichtung 21 erhöht ist.

Zwischen der Eintrittsebene 23 und der Austrittsebene 27 erstreckt sich eine zylindrische Außenelektrode 29, deren Zylinderrichtung und Symmetrieachse 35 mit einer Richtung 31 des Strahls 25 zusammenfällt. Die Außenelektrode 29 ist durch vier paarweise orthogonal zueinander angeordnete Plattenelektroden 33 gebildet, welche mit jeweils gleichem Abstand von der Längsachse 35 angeordnet sind. Eine jede der Plattenelektroden 33 ist aus einem vollflächigen elektrisch leitenden Material gebildet.

Die Emittanzänderungsvorrichtung 21 umfaßt ferner eine Innenelektrodenanordnung 37 aus einer Mehrzahl von Drähten 39, die sich jeweils parallel zur Längsachse 35 erstrecken. Die Drähte 39 sind innerhalb des durch die Platten 33 gebildeten Hohlraums angeordnet, wobei ein jeder Draht 39 von einer diesem unmittelbar benachbart angeordneten Platte 33 einen Abstand d=0,2mm aufweist. Die Drähte 39 sind somit auf vier Ebenen 41 angeordnet, welche sich parallel zu einer jeweiligen Platte 33 erstrecken, wobei eine jede der Ebenen 41 von der Längsachse 35 einen Abstand von D = 0,5mm aufweist. Die Drähte 39 sind zwischen einer auf der Eintrittsseite 23 angeordneten Rahmenhalterung 43 und einer auf der Austrittsseite 27 angeordneten Rahmenhalterung 45 gespannt und mit diesen elektrisch leitend verbunden.

Die Emittanzänderungsvorrichtung 21 umfaßt ferner eine Spannungsquelle 47, welche einerseits mit einer Leitung 49 an die Außenelektrodenanordnung 29 und andererseits über eine Leitung 51 über eine der Rahmenhalterungen 43, 45 an die Innenelektrodenanordnung 37 angeschlossen ist, wobei die Innenelektrodenanordnung 37 auf Massepotential liegt. Die Spannungsquelle 47 erzeugt zwischen Innenelektrodenanordnung 37 und Außenelektrodenanordnung 29 eine Potentialdifferenz von 10V, so daß die Außenelektrodenanordnung 29 auf einem Potential von +10V gegenüber Masse liegt.

Es entsteht somit in einem Raum 61 zwischen Innen- und Außenelektrodenanordnung ein elektrisches Feld, dessen Verlauf in Figur 3 durch Feldlinien 53 schematisch angedeutet ist. Für einen Raum 57 innerhalb der Innenelektrodenanordnung 37 wirkt letztere wie ein Faraday'scher Käfig, so daß dieser Raum im wesentlichen feldfrei ist.

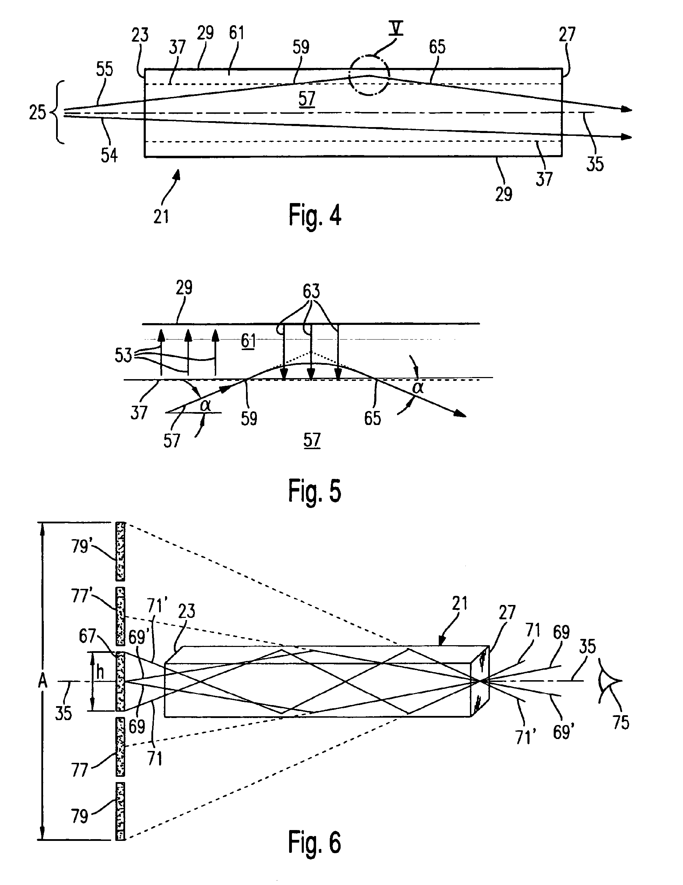

Figur 4 zeigt zwei Trajektorien 54 und 55 von Elektronen des Strahls 25, die die Emittanzänderungsvorrichtung 21 durchlaufen. Die Trajektorie 54 besitzt beim Eintritt in die Vorrichtung 21 eine geringe Divergenz bzw. einen geringen Winkel zur Mittelachse 35 und verläuft damit gänzlich in dem Innenraum 57, weshalb sie die Vorrichtung 21 geradlinig durchsetzt. Im Unterschied dazu verläuft die Trajektorie 55 bei ihrem Eintritt in die Vorrichtung 21 unter einem größeren Winkel zur Längsachse 35, so daß sie an einem Ort 59 die Innenelektrodenanordnung 37 durchsetzt, indem das entsprechende Elektron zwischen zwei benachbarten Drähten 39 hindurchfliegt und in den Zwischenraum zwischen Innenelektrode 37 und Außenelektrode 29 eintritt. Dies ist in Figur 5 vergrößert dargestellt. Aufgrund des in dem Zwischenraum 61 vorliegenden elektrischen Feldes (vergleiche Feldlinien 53) wirkt auf das Elektron eine den Feldlinien 53 entgegengesetzte Kraft, welche in Figur 5 durch Pfeile 63 angedeutet ist. Diese Kraft 63 reduziert eine quer zur Längsachse 35 orientierte Bewegungskomponente des in dem Zwischenraum 61 sich bewegenden Elektrons und kehrt die bei Eintritt am Ort 59 in den Zwischenraum 61 vorliegende Bewegungskomponente quer zur Längsachse 35 schließlich um, so daß das Elektron den Zwischenraum 61 an einem Ort 65 wieder verläßt, indem es zwischen zwei Drähten 39 der inneren Elektrodenanordnung 37 hindurchfliegt und wieder in den feldfreien Innenraum 57 gelangt, in dem es dann geradlinig weiterfliegt und die Emittanzänderungsvorrichtung 21 an deren Austrittsende 27 verläßt. Der Zwischenraum 61 zwischen der Innen- und Außenelektrode wirkt somit auf ein Elektron, welches die Innenelektrode 37 durchsetzt, wie ein Planspiegel.

Figur 6 zeigt eine konzentrisch zur Mittelachse 35 der Emittanzänderung 21 und mit Abstand von der Eintrittsebene 23 der Vorrichtung 21 angeordnete Teilchenquelle 67, welche quer zur Längsachse 35 eine Ausdehnung h aufweist. In Figur 6 sind weiter beispielhaft eine Mehrzahl von Trajektorien für Elektronenbahnen eingezeichnet, nämlich zwei Trajektorien 69 und 69', welche zur Längsachse 35 einen solchen Winkel aufweisen, daß einmal eine Reflexion durch die Elektrodenanordnungen erfolgt. Ferner sind zwei Trajektorien 71 und 71' gezeigt, welche einen größeren Winkel zur Längsachse 35 aufweisen, so daß die entsprechenden Elektronen zweimal an den Elektrodenanordnungen reflektiert werden. Aus der Sicht eines in Strahlrichtung hinter dem Austrittsende 27 der Vorrichtung 21 angeordneten Betrachterauges 75 scheinen die auf den Trajektorien 69, 69', 71 und 71' sich bewegenden Elektronen von scheinbaren Strahlungsquellen 77, 77', 79 bzw. 79' herzukommen, welche in Richtung quer zur Längsachse 35 versetzt neben der wahren Strahlungsquelle 67 angeordnet sind. Hierbei sind die scheinbaren Quellen 79 und 79', die durch die Trajektorien 71 bzw. 71' erzeugt werden, welche eine zweifache Reflexion an der Vorrichtung 21 erfahren, weiter von der Längsachse 35 entfernt angeordnet als die scheinbaren Quellen 77 und 77', welche durch die Trajektorien 69 bzw. 69' erzeugt werden, welche lediglich eine einfache Reflexion an der Vorrichtung 21 erfahren.

Somit wirkt die Emittanzänderungsvorrichtung 21 aus der Sicht des Betrachters 75 derart, daß dieser insgesamt Strahlung wahrnimmt, die von einer Strahlungsquelle zu stammen scheint, welche quer zur Längsachse 35 eine Ausdehnung A aufweist, die in dem in Figur 6 beschriebenen Beispiel, in dem aufgrund der begrenzten Strahldivergenz maximal zwei Reflexionen an der Emittanzänderungsvorrichtung 21 auftreten, dem fünffachen Wert der Ausdehnung h der wahren Quelle 67 entspricht. Die Divergenz, das heißt der Winkel zur Längsachse 35 bzw. eine Winkelverteilung der an dem Austrittsende 27 der Vorrichtung 21 austretenden Strahlen ist hierbei durch die Vorrichtung 21 im Vergleich zum Eintritt der Strahlen an dem Eintrittsende 23 nicht verändert. Da allerdings die scheinbare Fläche der Quelle aufgrund der Vorrichtung 21 erhöht ist, hat die Vorrichtung 21 den Lichtleitwert bzw. die Emittanz des Strahls, welche als das Produkt aus Quadratwurzel der beleuchteten Fläche und der Beleuchtungsdivergenz definiert ist, erhöht.

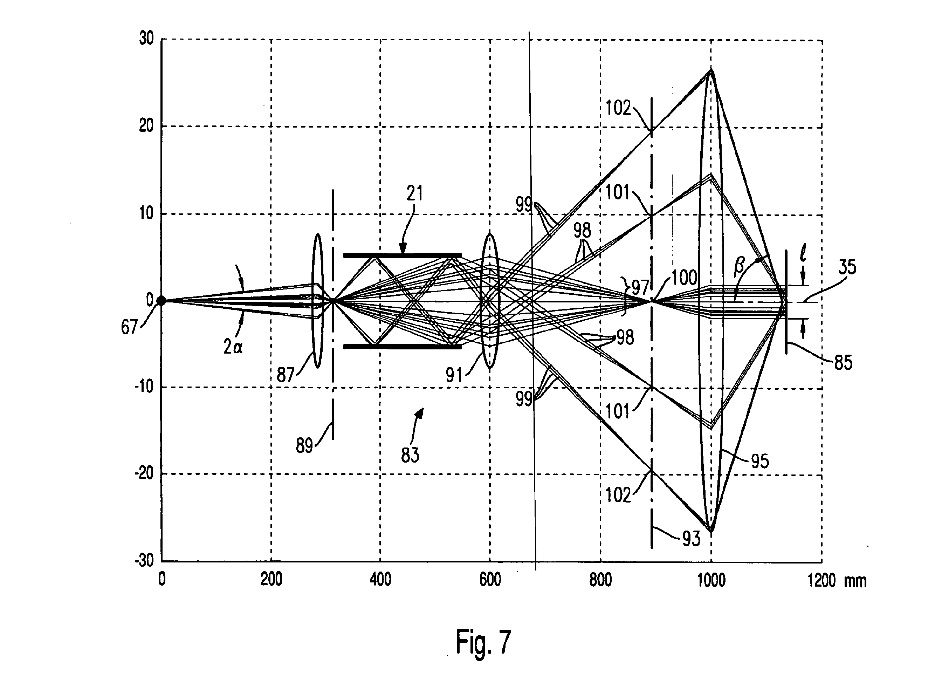

Figur 7 zeigt ein Ausführungsbeispiel eines Beleuchtungssystem 83, in das die Emittanzänderungsvorrichtung 21 integriert ist. Die Längsachse 35 der Emittanzänderungsvorrichtung 21 ist dabei so ausgerichtet, daß sie mit der optischen Achse des Beleuchtungssystems 83 zusammenfällt.

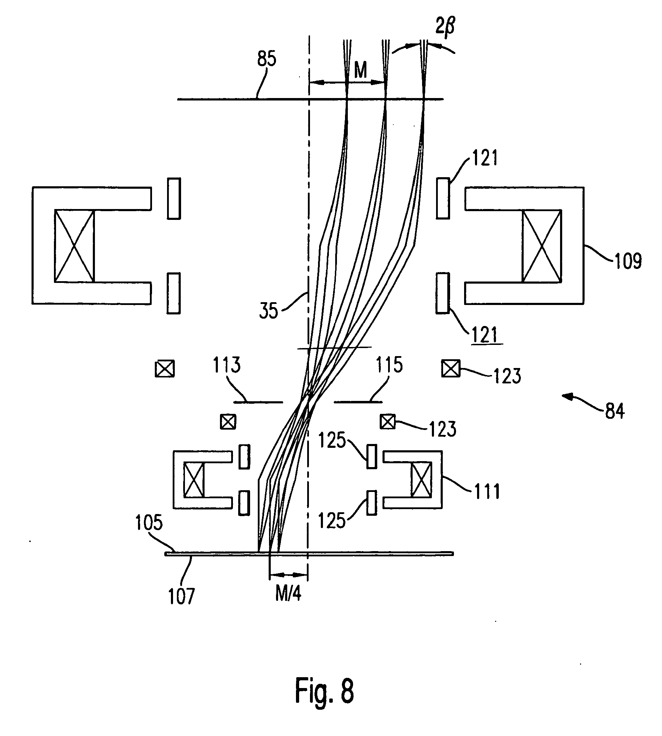

Das Beleuchtungssystem 83 ist Teil eines Lithographiesystems, das ferner ein Projektionssystem 84 umfaßt, welches nachfolgend im Zusammenhang mit Figur 8 erläutert ist. Ein beleuchtetes Objekt 85 ist hierbei eine Maske, auf der Muster definiert sind, welche mit dem Projektionssystem 84 auf eine strahlungsempfindliche Schicht 105 eines Halbleiter-Wafers 107 projiziert werden. Die Strahlungsquelle 67 ist eine thermische Elektronenquelle, bei der die von der auf etwa 2.000K geheizten Kathode emittierten Elektroden durch eine Spannung von 100kV in Richtung der optischen Achse 35 beschleunigt werden. Die kinetische Energie der Elektronen in Richtung der Achse 35 beträgt somit 100keV, während die kinetische Energie senkrecht zur Achse 35 maximal etwa 0,2eV beträgt. Ein maximaler Winkel $\alpha$, den die Trajektorie eines von der Quelle 67 emittierten Elektrons maximal zur optischen Achse 35 einnimmt, beträgt somit etwa 1,4mrad.

Eine Fokussierlinse 87 erzeugt in einer Ebene 89 ein 10fach verkleinertes Bild der Quelle 67. Eine weitere Fokussierlinse 91 ist so auf der optischen Achse angeordnet, daß sie das Bild der Quelle 67 in der Ebene 89 in eine Zwischenbildebene 93 abbildet. Zwischen der Ebene 89 und der Fokussierlinse 91 ist die Emittanzänderungseinrichtung 21 angeordnet, wobei diese in Richtung der optischen Achse 35 eine Länge von 200mm und quer dazu eine Kantenlänge von etwa 10mm*10mm aufweist.

Die Zwischenbildebene 93 wird von einer dritten Fokussierlinse 95 auf die Maske 85 nach Unendlich abgebildet. In Figur 7 sind lediglich exemplarisch einige Trajektorien von Elektronen auf ihrem Weg von der Quelle 67 zur Maske 85 dargestellt. Eine Gruppe 97 der in Figur 7 dargestellten Trajektorien gehört zu den Elektronen, die von der Quelle 67 unter einem so kleinen Winkel $\alpha$ zur Achse 35 emittiert werden, daß sie die Emittanzänderungsvorrichtung 21 ohne Reflexion durchlaufen. Für diese Elektronen erzeugt die Fokussierlinse 91 in der Zwischenebene 93 ein Zwischenbild 100 der Quelle 67, das auf der Längsachse 35 angeordnet ist. Diese Trajektorien werden durch die Fokussierlinse 95 parallelisiert, so daß sie bei ihrem Auftreffen auf die Maske 85 einen sehr kleinen Winkel $\beta$ zur Achse 35 einschließen.

Eine weitere Gruppe 98 von Trajektorien gehört zu solchen Elektronen, welche von der Quelle 67 in einem solchen Bereich des Winkels $\alpha$ zur Achse 35 emittiert werden, daß sie in der Emittanzänderungsvorrichtung 21 einmal reflektiert werden. Für diese Elektronen erzeugt die Fokussierlinse 91 in der Zwischenbildebene 93 ein Zwischenbild 101, welches mit Abstand von der optischen Achse 35 angeordnet ist. Die Fokussierlinse 95 richtet auch diese Elektronen auf die Maske 85, wobei sie sich dort mit den Elektronen des Bündels 97 überlagern, dort allerdings unter einem wesentlich größeren Winkel β zur Achse 35 auftreffen.

Eine noch weitere Gruppe 99 von Trajektorien gehört zu den Elektronen, welche mit nahezu maximalem Emittanzwinkel α von der Quelle 67 emittiert werden. Diese Elektronen werden in der Emittanzänderungsvorrichtung 21 zweimal reflektiert, und die Fokussierlinse 91 erzeugt für diese Elektronen ein Bild 102 des Bildes der Quelle 67 in der Ebene 89. Diese nach zweifacher Reflexion in der Emittanzänderungsvorrichtung 21 entstandenen Bilder 102 der Quelle 67 sind von der optischen Achse 35 mit einem noch größeren Abstand angeordnet als die Bilder 101 der Elektronen, die lediglich einmal in der Emittanzänderungsvorrichtung 21 reflektiert wurden.

Auch die Bilder 102 werden von der Fokussierlinse 95 auf die Maske 85 als im wesentlichen paralleles Strahlenbündel gerichtet, wobei sie sich mit den Elektronen der Bündel 97 und 98 überlagern und mit noch einem größeren Winkel β zur Achse 35 auf die Maske 85 treffen.

Der Winkel β zur Längsachse 35 für die zuletzt genannte Gruppe 99 von Trajektorien stellt hierbei die maximale Beleuchtungsapertur dar und ist wesentlich größer als der maximale Divergenzwinkel α der Quelle 67, obwohl auf der Maske 85 ein quadratisches Feld mit einer Kantenlänge 1 von etwa 1mm beleuchtet wird. Dieses Feld wird hierbei trotz seiner im Vergleich zur Ausdehnung des Quelle 67 relativ großen Ausdehnung im wesentlichen homogen ausgeleuchtet. Aus Figur 7 ist dabei auch ersichtlich, daß die Kantenlänge 1 des beleuchteten Feldes geringer ist als der Abstand der Zwischenbilder 101 und 102 von der Längsachse 35.

Das in Figur 8 gezeigte Projektionssystem 84 bildet die Maske 85 auf eine strahlungsempfindliche Schicht 105 ab, die auf der der Maske 85 zugewandten Seite eines Halbleiter-Wafers 107 aufgebracht ist. Hierzu umfaßt das Projektionssystem 84 ein Duplett aus Magnetlinsen 109 und 111, welches auf der Maske definierte Strukturen und Muster um einen Faktor 4 verkleinert auf die strahlungsempfindliche Schicht 105 abbildet. In Figur 8 sind exemplarisch drei Gruppen von Trajektorien mit unterschiedlichem Abstand M von der optischen Achse 35 dargestellt, wobei aus Figur 8 auch ersichtlich ist, daß die Maske 85 durch das in Figur 7 dargestellte Beleuchtungssystem 83 mit einer Beleuchtungsapertur β beleuchtet wird.

Das Duplett aus Fokussierlinsen 109 und 111 leitet die Trajektorien durch eine Symmetrieebene 113, an welcher für die Strahlen ein Cross-Over gebildet ist, das heißt die Trajektorien schneiden dort die optische Achse 35. In dieser Symmetrieebene 113 ist auch eine Aperturblende 115 vorgesehen, welche von den Strahlen durchsetzt wird, die die Maske 85 ungestreut durchlaufen haben, während die Elektronen, die von der Maske 85 leicht aus ihrer ursprünglichen Bahn herausgestreut werden, durch die Blende 115 absorbiert werden und damit nicht auf die strahlungsempfindliche Schicht gelangen.

Die Bezugzeichen 121, 123 und 125 bezeichnen in Figur 8 Hilfsspulen, welche ergänzend zu den Fokussierlinsen 109 und 111 Magnetfelder bereitstellen und welche derart angesteuert werden können, daß Abbildungsfehler bei der Projektion der Maske 85 auf die strahlungsempfindliche Schicht 105 reduziert werden.

In den vorangehend beschriebenen Ausführungsbeispielen wurde die Emittanzänderungsvorrichtung in einem Beleuchtungssystem und einem Projektionssystem eingesetzt, welches zur Abbildung einer Maskenstruktur auf ein Substrat dient. Auf derartige Anwendung ist die Emittanzänderungsvorrichtung 21 jedoch nicht beschränkt. Sie kann überall dort eingesetzt werden, wo für geladene Teilchen ein Eingriff auf deren Trajektorien vorgenommen werden soll, wobei die Wirkung bzw. die Änderung der Trajektorie von einem Winkel der Trajektorie bezüglich einer optischen Achse vor Eintritt in die Emittanzänderungsvorrichtung abhängig ist.

Ferner wurde vorangehend die Emittanzänderungsvorrichtung derart beschrieben, daß sie eine Innenelektrodenanordnung und eine Außenelektrodenanordnung aufweist, welche jeweils einen quadratischen Querschnitt haben. Es sind jedoch auch andere Geometrien hierfür denkbar. Insbesondere können die Innen- und Außenelektrodenanordnungen kreiszylindrische oder beliebige andere Gestalten haben.

Vorangehend wurde die Anordnung der zylindrischen Elektrodenanordnung der Emittanzänderungsvorrichtung als symmetrisch zum einfallenden Strahl dargestellt. Es ist jedoch auch möglich, zwischen einfallendem Strahl und Zylinderlängsachse einen Winkel vorzusehen oder die Zylinderlängsachse parallel zum einfallenden Strahl zu versetzen.

Bei dem in Figur 7 beschriebenen Ausführungsbeispiel wird durch das Kondensorsystem ein Bild der Quelle in die Zwischenbildebene abgebildet. Es ist jedoch ebenfalls möglich, die Quelle selbst in die Zwischenbildebene abzubilden.

In dem vorangehenden Ausführungsbeispiel sind die Teilelektroden der Emittanzänderungsvorrichtung als gespannte Drähte beschrieben. Alternativ hierzu ist es möglich, die Teilelektroden durch andere Maßnahmen auszubilden. Eine Möglichkeit hierzu ist es ebenfalls, die Teilelektroden lithographisch herzustellen, indem die Ausnehmungen zwischen benachbarten Teilelektroden durch ein Ätzverfahren aus einem Vollmaterial herausgebildet werden.

**Patentansprüche**

1. Teilchenoptische Vorrichtung zum Ändern von Trajektorien (55, 98, 99) geladener Teilchen eines entlang einer Längsachse (35) orientierten divergenten Teilchenstrahls (25), umfassend:

eine für die Teilchen wenigstens teilweise transparente Innenelektrodenanordnung (37), welche die Längsachse (35) mit radialem Abstand (D) wenigstens teilweise umgreift und sich entlang der Längsachse (35) erstreckt, wobei die Innenelektrodenanordnung (37) eine Mehrzahl von in Umfangsrichtung um die Längsachse (35) mit Abstand voneinander angeordneten Teilelektroden (39) umfaßt,

eine Außenelektrodenanordnung (29), welche die Innenelektrodenanordnung (37) bezüglich der Längsachse (35) mit radialem Abstand (d) wenigstens teilweise umgreift und sich entlang der Längsachse (35) erstreckt, und

eine Spannungsquelle (47) zum Bereitstellen einer Potentialdifferenz zwischen der Innenelektrodenanordnung (37) und der Außenelektrodenanordnung (29),

wobei die Spannungsquelle (47) ausgebildet ist, um eine solche Potentialdifferenz bereitzustellen, daß eine quer zur Längsachse (35) orientierte Bewegungskomponente eines die Innenelektrodenanordnung (37) durchsetzenden Teilchens umkehrbar ist; und

wobei die Vorrichtung ausgebildet ist, von Teilchen, welche mit geringer Divergenz in die Vorrichtung eintreten, geradlinig durchsetzt zu werden.

2. Vorrichtung nach Anspruch 1,
wobei die Teilelektroden (39) sich im wesentlichen parallel zur Längsachse (35) erstrecken.

3. Vorrichtung nach Anspruch 1 oder 2,
wobei die Teilelektroden durch eine Mehrzahl Drähte (39) gebildet sind, die zwischen einem eintrittsseitigen Halterahmen (43) und einem austrittsseitigen Halterahmen (45) für die Drähte (39) eingespannt sind.

4. Teilchenoptische Beleuchtungsvorrichtung zum Beleuchten eines in einer Objektebene angeordneten Objekts (85), umfassend:

eine Teilchenquelle (67) zur Emission eines Strahls geladener Teilchen,

eine zwischen der Teilchenquelle (67) und der Objektebene (85) angeordnete Emittanzänderungsvorrichtung (21), welche durch eine teilchenoptische Vorrichtung nach einem der Ansprüche 1 bis 3 gebildet ist und welche dazu ausgestaltet ist in sie von der Teilchenquelle (67) emittierte geladene Teilchen eintreten zu lassen,

ein Kondensorsystem, um von der Emittanzänderungsvorrichtung (21) austretende Teilchen auf die Objektebene (85) zu richten.

5. Beleuchtungsvorrichtung nach Anspruch 4,
wobei das Kondensorsystem eine erste Fokussierlinse (91) aufweist, welche die Quelle (67) oder ein in einer Quellbildebene (89) angeordnetes Bild der Quelle (67) in eine Zwischenebene (93) abbildet, wobei die Emittanzänderungsvorrichtung (21) zwischen der Quelle (67) bzw. der Quellbildebene (89) und der ersten Fokussierlinse (91) angeordnet ist, und wobei in der Zwischenebene (93) mehrere Bilder (101, 102) der Quelle (67) bzw. des Bildes der Quelle (67) erzeugt werden.

6. Beleuchtungsvorrichtung nach Anspruch 5,
wobei das Kondensorsystem eine zweite Fokussierlinse (95) aufweist, um die mehreren Bilder (101, 102) der Quelle, bzw. des Bildes der Quelle, in der Objektebene (85) zu überlagern.

7. Beleuchtungsvorrichtung nach Anspruch 6,
wobei die Zwischenebene (93) eine Brennebene der zweiten Fokussierlinse (95) ist.

8. Beleuchtungsvorrichtung nach einem der Ansprüche 4 bis 7,
wobei zwischen der Quelle (67) und der Emittanzänderungsvorrichtung (21) wenigstens eine dritte Fokussierlinse (87) vorgesehen ist, um das von der ersten Fokussierlinse (91) in die Zwischenebene (93) abgebildete Bild der Quelle (67) zu erzeugen.

9. Beleuchtungsvorrichtung nach Anspruch 4,
wobei das Kondensorsystem eine erste Fokussierlinse (91) aufweist, welche ausgestaltet ist, die Teilchen, nach Durchlaufen der Emittanzänderungsvorrichtung, durch eine zwischen der Objektebene (85) und der ersten Fokussierlinse (91) angeordnete Zwischenebene (93) zu lenken, und zwar derart, daß ein jedes Teilchen die Zwischenebene (93) mit einem Abstand von der Längsachse (35) durchsetzt, der um so größer ist, je öfter die orthogonal zur Längsachse (35) orientierte Bewegungskomponenete des Teilchens durch die Emittanzänderungsvorrichtung (21) geändert wurde.

10. Beleuchtungsvorrichtung nach Anspruch 9,
wobei das Kondensorsystem eine zweite Fokussierlinse (95) aufweist, um die Teilchen nach Durchlaufen der Zwischenebene (93) auf die Objektebene (85) zu richten,
wobei ein maximaler Abstand von der Längsachse, mit dem die Teilchen auf die Objektebene (85) treffen, geringer ist als ein maximaler Abstand, mit dem die entsprechenden Teilchen die Zwischenebene (93) durchsetzen.

11. Abbildungssystem zur Übertragung eines auf einer Maske (85) definierten Musters mittels eines Strahls geladener Teilchen auf ein in einer Substratebene anordenbares teilchenempfindliches Substrat (105), umfassend:

ein Beleuchtungssystem (83) zum Beleuchten der Maske (85) mit dem Strahl geladener Teilchen und eine teilchenoptische Abbildungsvorrichtung (84) zum Abbilden der Maske (85) auf das Substrat (105),

wobei das Beleuchtungssystem (83) eine Beleuchtungsvorrichtung gemäß einem der Ansprüche 4 bis 10 umfaßt, in deren Objektebene die Maske (85) angeordnet ist.

12. Verfahren zur Herstellung eines Bauelements, umfassend wenigstens einen photolithographischen Schritt, wobei der photolithographische Schritt umfaßt:

Bereitstellen des Abbildungsystems nach Anspruch 11,

Anordnen eines mit einer teilchenempfindlichen Schicht versehenen Substrats in der Substrateebene, und

Belichten des teilchenempfindlichen Substrats mittels des Projektionssystems, wobei ein durch die Maske bereitgestelltes Muster auf die teilchenempfindliche Schicht übertragen wird.

**Claims**

1. A particle-optical apparatus for changing trajectories (55, 98, 99) of charged particles of a divergent particle beam (25) oriented along a longitudinal axis (35), comprising:

an inner electrode arrangement (37) which is at least partially transparent for the particles, said inner electrode arrangement surrounding at least partially the longitudinal axis (35) with a radial distance (D) therefrom and extending along the longitudinal axis (35), said inner electrode arrangement (37) comprising a plurality of sub-electrodes (39) arranged spaced apart from each other in circumferential direction around the longitudinal axis (35),

an outer electrode arrangement (29) which surrounds at least partially the inner electrode arrangement (37) relative to the longitudinal axis (35) with a radial distance (d) therefrom and extends along the longitudinal axis (35), and

a voltage source (47) for providing a potential difference between the inner electrode arrangement (37) and the outer electrode arrangement (29),

wherein the voltage source (47) provides such a potential difference that a kinetic component of a particle traversing the inner electrode arrangement (37) is reversible, said kinetic component being oriented transversely to the longitudinal axis (35); and wherein the apparatus is arranged such that particles which enter the apparatus with little divergence pass therethrough straightly.

2. The apparatus according to claim 1, wherein the sub-electrodes (39) extend substantially parallel to the longitudinal axis (35).

3. The apparatus according to claim 1 or 2, wherein the sub-electrodes are formed by a plurality of wires (39) which are clamped between an entrance side mounting frame (43) for the wires (39) and an exit side mounting frame (45) for the wires (39).

4. A particle-optical illumination apparatus for illuminating an object (85) disposed in an object plane, comprising:

a particle source (67) for emitting a beam of charged particles,
an emittance changing apparatus (21) disposed between the particle source (67) and the object plane (85) which is formed by a particle-optical apparatus according to one of claims 1 to 3 and which is adapted to have charged particles enter therein which are emitted by the particle source (67),
a condenser system for directing particles emerging from the emittance changing apparatus (21) onto the object plane (85).

5. The illumination apparatus according to claim 4, wherein the condenser system comprises a first focusing lens (91) which images the source (67) or an image of the source (67) disposed in a source image plane (89) into an intermediate plane (93),
wherein the emittance changing apparatus (21) is disposed between the source (67) or the source image plane (89) and the first focusing lens (91),
and wherein several images (101, 102) of the source (67) or the image of the source (67) are generated in the intermediate image plane (93).

6. The illumination apparatus according to claim 5, wherein the condenser system comprises a second focusing lens (95) for superposing the plurality of images (101, 102) of the source or of the image of the source in the object plane (85).

7. The illumination apparatus according to claim 6, wherein the intermediate plane (93) is a focal plane of the second focusing lens (95).

8. The illumination apparatus according to one of claims 4 to 7, wherein at least a third focusing lens (87) is provided between the source (67) and the emittance changing apparatus (21) for producing the image of the source (67) imaged by the first focusing lens (91) into the intermediate plane (93).

9. The illumination apparatus according to claim 4, wherein the condenser system comprises a first focusing lens (91) which is adapted for guiding the particles, after the same have traversed the emittance changing apparatus, through an intermediate plane (93) disposed between the object plane (85) and the first focusing lens (91) such that each particle traverses the intermediate plane (93) spaced apart from the longitudinal axis (35) by a distance which increases the more often the kinetic component of the particle oriented orthogonally to the longitudinal axis (35) has been changed by the emittance changing apparatus (21).

10. The illumination apparatus according to claim 9, wherein the condenser system comprises a second focusing lens (95) for orienting the particles onto the object plane (85) after the same have traversed the intermediate plane (93), a maximum distance from the longitudinal axis at which the particles impinge on the object plane (85) being less than a maximum distance at which the corresponding particles traverse the intermediate plane (93).

11. An imaging system for transferring a pattern defined on a mask (85) onto a particle-sensitive substrate (105) disposable in a substrate plane by means of a beam of charged particles, comprising:

an illumination system (83) for illuminating the mask (85) with a beam of charged particles and a particle-optical imaging apparatus (84) for imaging the mask (85) onto the substrate (105), wherein the illumination system (83) comprises an illumination apparatus according to one of claims 4 to 10, the mask (85) being disposed in the object plane thereof.

12. A method for device manufacture, comprising at least one photolithographic step, wherein the photolithographic step comprises:

providing the imaging system according to claim 11,
disposing a substrate having applied thereon a particle-sensitive layer in the substrate plane, and
exposing the particle-sensitive substrate by means of the projection system, whereby a pattern provided by the mask is transferred to the particle-sensitive layer.

**Revendications**

1. Dispositif d'optique corpusculaire pour la modification des trajectoires (55, 98, 99) de particules chargées d'un faisceau de particules divergent (25) orienté le long d'un axe longitudinal (35), comprenant :

un dispositif d'électrode interne (37) au moins partiellement transparent pour les particules, lequel entoure au moins partiellement l'axe longitudinal (35) avec une distance radiale (D) et qui s'étend le long de l'axe longitudinal (35), le dispositif d'électrode interne (37) comprenant une pluralité d'électrodes partielles (39) espacées les unes des autres,
un dispositif d'électrode externe (29) qui entoure au moins partiellement le dispositif d'électrode interne (37) par rapport à l'axe longitudinal (35) à une distance radiale (d) et qui s'étend le long de l'axe longitudinal (35) et une source de tension (47) permettant d'appliquer une différence potentiel entre le dispositif d'électrodes internes (37) et le dispositif d'électrode externe (29),
la source de tension (47) étant réalisée afin d'appliquer une différence de potentiel de façon à ce qu'une composante du mouvement, orientée transversalement par rapport à l'axe longitudinal (35), d'une particule traversant le dispositif d'électrode interne (37) puisse être inversée ; et le dispositif étant réalisé pour être traversé en ligne droite par des particules qui entrent avec une faible divergence dans le dispositif.

2. Dispositif selon la revendication 1, dans lequel les électrodes partielles (39) s'étendent de manière sensiblement parallèle à l'axe longitudinal (35).

3. Dispositif selon la revendication 1 ou 2, dans lequel les électrodes partielles sont formées par une pluralité de fils (39), qui sont tendus entre un cadre de support (43) du côté de l'entrée et un cadre de support (45) du côté de la sortie pour les fils (39).

4. Dispositif d'illumination d'optique corpusculaire pour l'illumination d'un objet (85) disposé dans un plan objet, comprenant :

une source de particules (67) permettant l'émission d'un faisceau de particules chargées,
un dispositif de modification de l'émittance (21) disposé entre la source de particules (67) et le plan objet (85), lequel dispositif est formé par un dispositif d'optique corpusculaire selon l'une quelconque des revendications 1 à 3 et qui est conçu pour laisser entrer les particules chargées émises par la source de particules (67),
un système de condenseur permettant d'orienter les particules sortant du dispositif de modification de l'émittance (21) sur le plan de l'objet (85).

**5.** Dispositif d'illumination selon la revendication 4, dans lequel
le système de condenseur comprend une première lentille de focalisation (91), qui représente la source (67) ou une image de la source (67) disposée dans un plan image de la source (89) dans un plan intermédiaire (93),
le dispositif de modification de l'émittance (21) étant disposé entre la source (67) et où le plan image de la source (89) et la première lentille de focalisation (91),
et plusieurs images (101, 102) de la source (67) et/ou de l'image de la source (67) sont produites dans le plan intermédiaire (93).

**6.** Dispositif d'illumination selon la revendication 5, dans lequel
le système de condenseur présente une deuxième lentille de focalisation (95) afin de superposer les multiples images (101, 102) de la source et/ou de l'image de la source dans le plan objet (85).

**7.** Dispositif d'illumination selon la revendication 6, dans lequel
le plan intermédiaire (93) est un foyer de la deuxième lentille de focalisation (95).

**8.** Dispositif d'illumination selon l'une quelconque des revendications 4 à 7, dans lequel
au moins une troisième lentille de focalisation (87) est prévue entre la source (67) et le dispositif de modification de l'émittance (21) afin de produire l'image de la source (67) représentée dans le plan intermédiaire (93) par la première lentille de focalisation (91).

**9.** Dispositif d'illumination selon la revendication 4, dans lequel
le système de condenseur présente une première lentille de focalisation (91), laquelle est réalisée de façon à diriger les particules, après la traversée du dispositif de modification de l'émittance, à travers un plan intermédiaire (93) disposé entre le plan objet (85) et la première lentille de focalisation (91) de façon à ce que chaque particule traverse le plan intermédiaire (93) à une distance de l'axe longitudinal (35) qui est d'autant plus importante que la composante de mouvement de la particule orientée le plus souvent orthogonalement par rapport à l'axe longitudinal (35) a été modifiée fréquemment par le dispositif de modification de l'émittance (21).

**10.** Dispositif d'illumination selon la revendication 9, dans lequel
le système de condenseur présente une deuxième lentille de focalisation (95) afin d'orienter les particules, après la traversée du plan intermédiaire (93), sur le plan objet (85), la distance maximale par rapport à l'axe longitudinal, avec laquelle les particules arrivent sur le plan de l'objet (85) étant inférieure à la distance maximale avec laquelle ces mêmes particules traversent le plan intermédiaire (93).

**11.** Système de reproduction permettant la transmission d'un motif défini sur un masque (85) à l'aide d'un faisceau de particules chargées sur un substrat sensible aux particules (105) pouvant être disposé dans un plan de substrat, comprenant :

un système d'illumination (83) permettant d'illuminer le masque (85) avec le faisceau de particules chargées et un dispositif de reproduction à optique corpusculaire (84) pour la reproduction du masque (85) sur le substrat (105),
le système d'illumination (83) comportant un dispositif d'illumination selon l'une quelconque des revendications 4 à 10, dans le plan objet duquel se trouve le masque (85).

**12.** Procédé de fabrication d'un composant comprenant au moins une étape photolithographique, l'étape photolithographique comportant :

la réalisation du système de reproduction selon la revendication 11,
la disposition d'un substrat muni d'une couche sensible aux particules dans le plan du substrat, et
l'éclairage du substrat sensible aux particules à l'aide du système de projection, un motif réalisé par le masque étant transmis sur la couche sensible aux particules.

Fig. 1

Fig. 2

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5079112 A
- US 5130213 A
- US 5260151 A
- US 5376505 A
- US 5258246 A
- US 5316879 A
- EP 0953876 A2
- EP 0969326 A2
- GB 1469415 A

**In der Beschreibung aufgeführte Nicht-Patentliteratur**

- SCALPEL: A Projection Electron-Beam Approach to Sub-Optical Lithography. **VON J. A. LIDDLE ; LLOYD R. HARRIOTT ; A.E. NOVEMBRE ; W. K. WASKIEWICZ.** Technology Review. Bell Laboratories, Lucent Technologies, Dezember 1999
- **VON D. MOONEN.** Grid lens approach for high effective emittance in SCALPEL. *Journal for Vacuum Sience Technology,* November 2000